Europäisches Patentamt

European Patent Office

Office européen des brevets

(19)

(11) Veröffentlichungsnummer: **0 199 280 B1**

## (12) EUROPÄISCHE PATENTSCHRIFT

(45) Veröffentlichungstag der Patentschrift: **13.03.91**

(21) Anmeldenummer: **86105273.6**

(22) Anmeldetag: **16.04.86**

(51) Int. Cl.⁵: **H01F 15/04,** H01F 5/02,
H05K 9/00, H05K 5/00,
H01F 15/10

(54) Kontaktierung metallbeschichteter Kunststoffteile eines Wickelkörpers.

(30) Priorität: **19.04.85 DE 3514342**

(43) Veröffentlichungstag der Anmeldung:
**29.10.86 Patentblatt 86/44**

(45) Bekanntmachung des Hinweises auf die
Patenterteilung:
**13.03.91 Patentblatt 91/11**

(84) Benannte Vertragsstaaten:
**AT CH DE FR GB IT LI NL SE**

(56) Entgegenhaltungen:
**DE-A- 3 100 419**

**IBM TECHNICAL DISCLOSURE BULLETIN
Band 27, nr 1A, Juni 1984, Seiten 146-148,
New York US; RP Maroon et al: "Solder-Free
printed circuit mountable transformer"**

(73) Patentinhaber: **Siemens Aktiengesellschaft
Wittelsbacherplatz 2
W-8000 München 2(DE)**

(72) Erfinder: **Rückerl, Alfred, Dipl.-Ing. (FH)
Sentilostrasse 35
W-8000 München 71(DE)**
Erfinder: **Sepperl, Hans, Dipl.-Ing. (FH)
Lindenstrasse 10
W-8150 Holzkirchen(DE)**

## Beschreibung

Die Erfindung betrifft eine Vorrichtung gemäß dem Oberbegriff des Patentanspruches 1.

Zur Stromversorgung elektrischer Geräte, insbesondere elektrischer Büromaschinen werden in zunehmenden Maße Schaltnetzteile eingesetzt. Die in solchen Schaltnetzteilen im kHz-Bereich arbeitenden Umrichterschaltungen benötigen Übertrager, die neben der Energietransformation und der galvanischen Trennung zwischen Versorgungsnetz und Verbraucher auch die Aufgabe haben, die durch die schnellen Schaltvorgänge des elektronischen Schalters entstehenden Hochfrequenzstörungen zu dämpfen. Eine Reduzierung der Hochfrequenzstörungen auf den Leitungen zum einspeisenden Netz werden durch eine allseitige Schirmung der Primär- und Sekundärwicklung erreicht.

Da die Primär- und Sekundärwicklung meist nicht direkt auf den Übertragerkern gewickelt sind, sondern auf einen Wickelkörper, der über den Übertragerkern geschoben wird, sind dabei die Flächen des Wickelkörpers mit einer Schirmung zu versehen. Diese durch elementares Aufbringen von Metall direkt auf den Wickelkörpern entstandenen Metallschichten müssen zur Erreichung eines Abschirmeffektes elektrisch kontaktiert werden.

Es wurde bereits vorgeschlagen, metallische Verbindungsleitungen zwischen den metallischen Schirmflächen und den Anschlußstiften auf die Wickelkörper bzw. auf deren Anschlußplatten aufzudampfen. Aus der DE-A- 3100419 ist ein Übertrager hoher Leistungsdichte, insbesondere einen Hochspannungstransformator in einem Schaltregler bekannt, wobei die Primärspule und die Sekundärspule dieses Übertragers auf einem Spulenträger angeordnet sind der als Metallschirm zwischen den beiden Spulen dient und mit einem den Übertrager haltenden, metallischen Trägerteil elektrisch leitend verbindbar ist.

Diese metallischen Verbindungsleitungen sind aber an den Übergangsstellen zu den Anschlußstiften in Folge thermischer Belastung (Löt- und Betriebstemperatur), sowie unterschiedlichem Ausdehnungsverhalten stark rissgefährdet. Ein solcher Riss führt zur Unterbrechung des elektrischen Kontaktes und die HF-Schirmung wird damit wirkungslos.

Aufgabe der Erfindung ist es, eine auf Kunststoffteile aufgebrachte, dünne Metallschicht elektrisch so zu kontaktieren, daß eine mit geringem Aufwand herstellbare, gut leitende, elektrische Verbindung zwischen Metallschicht und einer z.B. auf einer Leiterplatte angeordneten Kontaktierungsfläche entsteht.

Diese Aufgabe wird erfindungsgemäß durch die im kennzeichnenden Teil des Patentanspruches 1 genannten Merkmale gelöst.

Vorteilhafte Ausführungsformen und Weiterbildungen der Erfindung sind in den Unteransprüchen gekennzeichnet.

Durch die Verwendung von federnd ausgeführten Kontaktansätzen und einem Verlängerungsteil, die an den Kunststoffteilen des Wickelkörpers ausgeformt sind und auf die sich jeweils die metallische Beschichtung der Kunststoffteile erstreckt, läßt sich mit Hilfe einer Verriegelungseinrichtung, die zugleich auch der Befestigung des gesamten Wickelkörpers auf der Leiterplatte dient, eine elektrische Verbindung zwischen den metallbeschichteten Kunststoffteilen des Wickelkörpers und den Kontaktierungsflächen auf der Leiterplatte herstellen. Hierzu befinden sich auf der Leiterplatte Kontaktierungsflächen, auf welche die Enden der Kontaktansätze angepreßt werden. Die Gegenkraft der Kontaktansätze wird dabei von einer Verriegelungseinrichtung aufgenommen, die zu diesem Zwecke in Durchbrüche der Leiterplatte reicht und diese uförmig umgreift.

Die Kontaktansätze werden beim Zusammenfügen der Kunststoffteile sowohl federnd zur Anlage an das Verlängerungsteil gebracht, wodurch der Kontakt zwischen den metallischen Beschichtungen untereinander hergestellt wird, als auch federnd zur Anlage an die Kontaktierungsflächen auf einer Leiterplatte.

Dadurch ergibt sich eine sichere, mechanisch stabile Kontaktierung der elektrischen Schirmflächen, die verschleißarm ist und einen geringen Übergangswiderstand aufweist.

Die Erfindung wird nachstehend anhand von in der Zeichnung dargestellten Ausführungsbeispielen erläutert. Dabei zeigen

Fig. 1 einen mit metallbeschichteten Flächen versehenen Wickelkörper zur direkten Kontaktierung auf einer Leiterplatte im Schnitt.

Fig. 2 einen mit metallbeschichteten Flächen versehenen Wickelkörper zur Kontaktierung mit einem auf einer Leiterplatte kontaktierten Anschlußstift im Schnitt.

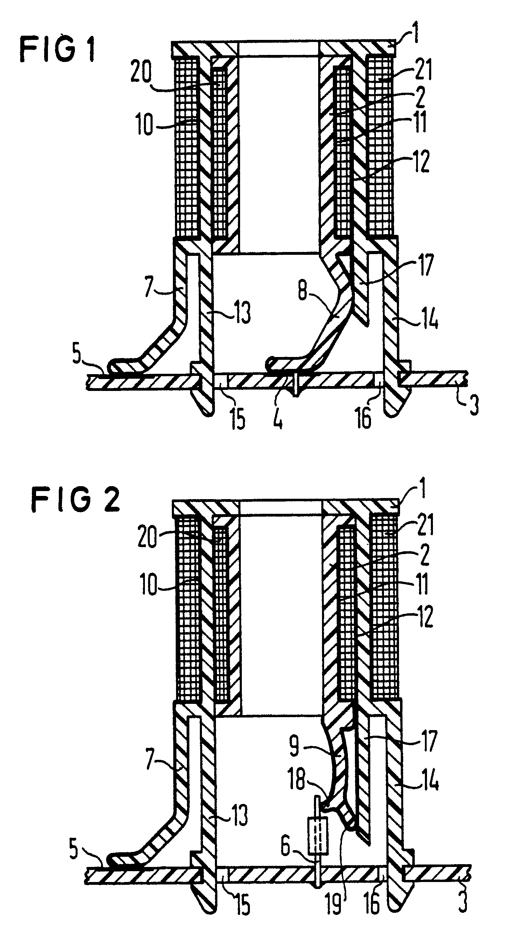

Der in Fig. 1 dargestellte Wickelkörper für Übertrager in Büromaschinen besteht aus einem äußeren und einem inneren Wickelkörper, im nachfolgenden als Kunststoffteile 1, 2 bezeichnet.

Die Kunststoffteile 1, 2 sind Hohlzylinder mit rechteckigen Querschnitten, wobei die Abmessungen des Kunststoffteils 2 so bemessen sind, daß es in das Kunststoffteil 1 geschoben und verriegelt werden kann. Der gesamte Wickelkörper wird dann über einen hier nicht näher dargestellten Übertragerkern geschoben.

Das Kunststoffteil 1 trägt auf seiner Außenfläche eine Sekundärwicklung 21, während auf die Außenfläche des Kunststoffteils 2 eine Primärwicklung 20 gewickelt ist.

Zur Reduzierung von Hochfrequenzstörungen weisen die Kunststoffteile 1, 2 als elektrische Schirmflächen wirkende, metallische Beschichtungen 10, 11, 12 auf. Hierzu ist auf die zur Primärwicklung 20 weisenden Fläche des Kunststoffteils 2 eine metallische Beschichtung 11 aufgebracht, die zur Vermeidung einer Kurzschlußwicklung in ihrer ganzen axialen Länge durch einen hier nicht dargestellten Spalt unterbrochen ist.

Das Kunststoffteil 1 weist an der zur Sekundärwicklung 21 gerichteten Außenfläche, die metallische Beschichtung 10 und an der zur Primärwicklung 20 gerichteten Innenfläche die metallische Beschichtung 12 auf. Diese beiden metallischen Beschichtungen 10, 12 sind ebenfalls zur Vermeidung einer Kurzschlußwicklung in ihrer ganzen axialen Länge durch einen hier nicht dargestellten Spalt unterbrochen.

Die metallischen Beschichtungen 10, 11, 12 können durch Aufdampfen, Galvanisieren oder andere elementare Prozesse direkt auf die Kunststoffteile 1, 2 aufgebracht werden.

Am Kunststoffteil 1 ist an einer zu einer Leiterplatte 3 zugewandten Stirnseite ein zungenartiger, in sich federnder Kontaktansatz 7 ausgeformt, über den sich die metallische Beschichtung 10 des Kunststoffteils 1 erstreckt. Dieser Kontaktansatz 7 verläuft von der Stirnseite des Kunststoffteils 1 ausgehend senkrecht zur Leiterplatte 3 und knickt im Bereich vor der Leiterplatte 3 stumpfwinklig zu dieser nach außen ab, wobei sich das Ende des Kontaktansatzes 7 federnd auf einer Kontaktierungsfläche 5 abstützt.

Außerdem ist am Kunststoffteil 1 an der der Leiterplatte 3 zugewandten Stirnseite eine mit einer Anlaufschräge versehenes Verlängerungungsteil 17 ausgebildet, über die sich die metallische Beschichtung 12 erstreckt, und dessen Länge so bemessen ist, daß das Verlängerungsteil 17 bei verriegeltem und befestigtem Wickelkörper auf der Leiterplatte 3 in den Bereich des Kontaktansatzes 8 hineinragt und diesen kontaktiert.

Das Kunststoffteil 2 weist analog zum Kunststoffteil 1 einen federnden Kontaktansatz 8 auf, der sich in seiner Ausgestaltung vom Kontaktansatz 7 nur dadurch unterscheidet, daß er ausgehend von der der Leiterplatte 3 zugewandten Stirnseite des Kunststoffteils 2 spitzwinklig zum Verlängerungsteil 17 abgeknickt ist und mit der metallischen Beschichtung 11 versehen ist.

Dadurch wird beim Zusammenfügen der Kunststoffteile 1, 2 der Kontaktansatz 8 zur Anlage an das Verlängerungsteil 17 gebracht und die metallischen Beschichtungen 11, 12 mit der Kontaktierungsfläche 4 auf der Leiterplatte 3 kontaktiert.

Die Gegenkraft der Kontaktansätze 7, 8 wird durch eine Verriegelungseinrichtung 13, 14 aufgenommen, die zugleich zur Befestigung des gesamten Wickelkörpers auf der Leiterplatte 3 dient. Die Verriegelung geschieht durch zwei am Kunststoffteil 1 angeformte Stege 13, 14. Die in sich federnden Stege 13, 14 verlaufen parallel zueinander in Richtung zu einer Leiterplatte 3 und weisen an den der Leiterplatte 3 zugewandten Enden eine spitzwinklig nach außen verlaufende Abschrägung auf. In Durchbrüchen 15, 16 der Leiterplatte 3 umgreifen die Stege 13, 14 mittels rechtwinklig ausgebildeter Aufnahmen die Leiterplatte 3 u-förmig.

Bei dem in Fig. 2 dargestellten Ausführungsbeispiel erfolgt die Kontaktierung der metallischen Beschichtungen 11, 12 der Kunststoffteile 1, 2 über einen in der Leiterplatte 3 kontaktierten Anschlußstift 6, während die Kontaktierung der metallischen Beschichtung 10, die Verriegelungseinrichtung 13, 14 und das Verlängerungsteil 17 identisch zu dem in Fig. 1 dargestellten Ausführungsbeispiels ist.

Zu diesem Zweck ist an das mit einer metallischen Beschichtung 11 versehene Kunststoffteil 2 an der einer Leiterplatte 3 zugewandten Stirnseite ein federnder Kontaktansatz 9 ausgeformt, der zwei Nocken 18, 19 aufweist und auf dessen Oberfläche sich die metallische Beschichtung 11 erstreckt.

Die Nocke 19 weist spitzwinklig zu einem Verlängerungsteil 17, während die Nocke 18 in Richtung zum Anschlußstift 6 zeigt. Über die Nocke 19 und dem Verlängerungsteil 17 werden beim Montieren der Konststoffteile 1, 2 die metallischen Beschichtungen 11, 12 untereinander kontaktiert und der Kontaktansatz 9 mittels der Nocke 18 zur Anlage an den Anschlußstift 6 gebracht.

## Ansprüche

1. Vorrichtung zum Herstellen einer elektrischen Verbindung zwischen Kunststoffteilen, die eine dünne metallische Beschichtung aufweisen, insbesondere mit einer elektrischen Schirmung (10, 11, 12) versehene Elemente (1, 2) eines Wickelkörpers für Übertrager mit auf einer Leiterplatte (3) befindlichen Kontaktierungsflächen (4, 5,6),
   **dadurch gekennzeichnet,**
   daß an den Kunststoffteilen (1, 2) zungenartige, sich auf den Kontaktierungsflächen (4, 5, 6) der Leiterplatte (3) federnd abstützende Kontaktansätze (7, 8, 9) ausgeformt sind, über die sich ebenfalls die metallische Beschichtung (10,11, 12) erstreckt.

2. Vorrichtung nach Anspruch 1,
   **dadurch gekennzeichnet,**
   daß das Kunststoffteil (1) eine aus zwei federnden Stegen (13, 14) gebildete, verrastbare Verriegelungseinrichtung aufweist, welche die Leiterplatte (3) in Durchbrüchen (15, 16) u-förmig umgreift.

3. Vorrichtung nach einem der Ansprüche 1 oder 2,
**dadurch gekennzeichnet,**
daß am Kunststoffteil (1) ein Verlängerungsteil (17) ausgeformt ist, auf die sich die metallische Beschichtung (12) erstreckt und dessen Länge so bemessen ist, daß es in den Bereich des Kontaktansatzes (8, 9) hineinragt und diesen kontaktiert.

4. Vorrichtung nach Anspruch 3,
**dadurch gekennzeichnet,**
daß das Verlängerungsteil (17) mit einer Anlaufschräge versehen ist.

5. Vorrichtung nach einem der Ansprüche 1 bis 3,
**dadurch gekennzeichnet,**
daß der Kontaktansatz (9) eine Nocke (18) aufweist, die durch Zusammenfügen der Kunststoffteile (1,2) zur Anlage an die Kontaktfläche (6) gebracht wird.

6. Vorrichtung nach Anspruch 5,
**dadurch gekennzeichnet,**
daß die Kontaktfläche (6) als ein in der Leiterplatte (3) kontaktierter Anschlußstift ausgebildet ist

## Claims

1. Device for producing an electrical connection between plastic components which have a thin metal coating, preferably elements (1, 2), provided with an electrical shielding (10, 11, 12), of a winding form for transformers with contact faces (4, 5, 6) located on a printed circuit board (3), characterized in that tongue-like contact extensions (7, 8, 9) which are braced resiliently on the contact faces (4, 5, 6) of the printed circuit board (3) are formed on the plastic components (1, 2), over which contact extensions the metallic coating (10, 11, 12) also extends.

2. Device according to Claim 1, characterized in that the plastic component (1) has a latchable locking device formed from two resilient webs (13, 14), said locking device engaging around the printed circuit board (3) in a U-shaped manner in through-holes (15, 16).

3. Device according to one of Claims 1 or 2, characterized in that an extension piece (17) is formed on the plastic component (1), onto which extension part the metallic coating (12) extends and the length of which is dimensioned in such a way that it projects into the region of the contact extension (8, 9) and makes contact with it.

4. Device according to Claim 3, characterized in that the extension piece (17) is provided with a run-in slope.

5. Device according to one of Claims 1 to 3, characterized in that the contact extension (9) has a cam (18) which is brought to rest against the contact face (6) by joining the plastic components (1, 2).

6. Device according to Claim 5, characterized in that the contact face (6) is constructed as a terminal pin in contact with the printed circuit board (3).

## Revendications

1. Dispositif pour établir une liaison électrique entre des pièces en matière plastique, qui possèdent un revêtement métallique mince, notamment des éléments (1,2), pourvus d'un blindage électrique (10,11,12), d'un corps de bobinage pour un transformateur, et des surfaces de contact (4,5,6) situées sur une plaquette à circuits imprimés (3), caractérisé par le fait que sur les pièces en matière plastique (1,2) sont formés par moulage des appendices de contact saillants (7,8,9) en forme de languettes, qui prennent appui élastiquement sur les surfaces de contact (4,5,6) de la plaquette à circuits imprimés (3) et sur lesquels s'étend également le revêtement métallique (10,11,12).

2. Dispositif suivant la revendication 1, caractérisé par le fait que la pièce en matière plastique (1) possède un dispositif de verrouillage encliquetable, qui est formé par deux barrettes élastiques (13,14) et enserre, avec une forme de u, la plaquette à circuits imprimés (3) au niveau d'ouvertures (15,16).

3. Dispositif suivant l'une des revendications 1 ou 2, caractérisé par le fait que sur la pièce en matière plastique (1) est formé par moulage un prolongement (17), sur lequel s'étend le revêtement métallique (12) et dont la longueur est dimensionnée de telle sorte que ce prolongement pénètre dans la zone de l'appendice saillant de contact (8,9) et établit un contact avec cet appendice saillant.

4. Dispositif suivant la revendication 3, caractérisé par le fait que le prolongement (17) comporte un biseau en forme de rampe.

5. Dispositif suivant l'une des revendications 1 à 3, caractérisé par le fait que l'appendice saillant de contact (9) comporte un ergot (18), qui vient s'appliquer contre la surface de contact (6), lors de la réunion des pièces en matière plastique (1,2).

6. Dispositif suivant la revendication 5, caractérisé par le fait que la surface de contact (6) est réalisée sous la forme d'une broche de raccordement établissant un contact dans la plaquette à circuits imprimés (3).

FIG 1

FIG 2